# EUROPÄISCHE PATENTANMELDUNG

(11) **EP 4 810 911 A1**
(43) Veröffentlichungstag der Anmeldung: **23.09.2026**
(21) Anmeldenummer: 26162172.6
(22) Anmeldetag: 04.03.2026
(51) Int. Cl.: G01C 15/00, H01S 5/02325, H05K 1/189, H01S 5/02212, H01S 5/0683

(54) **VERFAHREN ZUM BETREIBEN EINES ROTATIONSLASERS UND ROTATIONSLASER**

(30) Priorität: 20.03.2025 DE 102025110735
(71) Anmelder: Robert Bosch GmbH, 70442 Stuttgart (DE)
(72) Erfinder: Carabelli, Ben William, 70771 Leinfelden-Echterdingen (DE); Zibold, Tobias, 70567 Stuttgart (DE); Hahl, Markus, 70825 Korntal-Muenchingen (DE)

(57) **Zusammenfassung**

Ein Verfahren (500) zum Betreiben eines Rotationslasers, der zumindest in einer ersten Betriebsart oder einer zweiten Betriebsart betreibbar ist und ein Gehäuse aufweist, in dem zur Rotation eines Laserstrahls eine Antriebseinheit mit einem Stator und einem Rotor zum rotierenden Antreiben einer Spindel angeordnet ist, wobei der Antriebseinheit eine Steuer- und Regelungseinheit zum Ansteuern der Antriebseinheit zugeordnet ist, weist folgende Schritte auf: in Antwort auf eine Auswahl der ersten Betriebsart, Ansteuern der Antriebseinheit durch die Steuer- und Regelungseinheit mit einem der ersten Betriebsart zugeordneten ersten Ansteuerungsmodus, welchem eine bürstenlose Gleichstrommotor- Logik (521) zugeordnet ist; in Antwort auf eine Auswahl der zweiten Betriebsart, Ansteuern der Antriebseinheit durch die Steuer- und Regelungseinheit mit einem der zweiten Betriebsart zugeordneten zweiten Ansteuerungsmodus, welchem eine Schrittmotor-Logik (531) zugeordnet ist; und Antreiben der Antriebseinheit im ersten Ansteuerungsmodus, oder Antreiben der Antriebseinheit im zweiten Ansteuerungsmodus.

## Beschreibung

### Stand der Technik

Die vorliegende Erfindung betrifft ein Verfahren zum Betreiben eines Rotationslasers, der zumindest in einer ersten Betriebsart oder einer zweiten Betriebsart betreibbar ist und ein Gehäuse aufweist, in dem zur Rotation eines Laserstrahls eine Antriebseinheit mit einem Stator und einem Rotor zum rotierenden Antreiben einer Spindel angeordnet ist, wobei der Antriebseinheit eine Steuer- und Regelungseinheit zum Ansteuern der Antriebseinheit zugeordnet ist.

Aus dem Stand der Technik ist ein derartiges Verfahren zum Betreiben eines Rotationslaser bekannt, bei dem der Rotationslaser in einer ersten oder zweiten Betriebsart betreibbar ist. Hierzu weist der Rotationslaser ein Gehäuse auf, in dem zur Rotation eines Laserstrahls eine Antriebseinheit mit einem Stator und einem Rotor zum rotierenden Antreiben einer Spindel angeordnet ist. Der Antriebseinheit ist eine Steuer- und Regelungseinheit zum Ansteuern der Antriebseinheit zugeordnet. In Antwort auf eine Auswahl der ersten Betriebsart steuert die Steuer- und Regelungseinheit die Antriebseinheit mit einem der ersten Betriebsart zugeordneten Ansteuerungsmodus an. In Antwort auf eine Auswahl der zweiten Betriebsart steuert die Steuer- und Regelungseinheit die Antriebseinheit mit dem der ersten Betriebsart zugeordneten Ansteuerungsmodus an und es wird ein mechanisches Haltemoment zur Ausbildung der zweiten Betriebsart auf die Antriebseinheit gegeben.

### Offenbarung der Erfindung

Die Erfindung betrifft ein Verfahren zum Betreiben eines Rotationslasers, der zumindest in einer ersten Betriebsart oder einer zweiten Betriebsart betreibbar ist und ein Gehäuse aufweist, in dem zur Rotation eines Laserstrahls eine Antriebseinheit mit einem Stator und einem Rotor zum rotierenden Antreiben einer Spindel angeordnet ist, wobei der Antriebseinheit eine Steuer- und Regelungseinheit zum Ansteuern der Antriebseinheit zugeordnet ist. Das Verfahren weist folgende Schritte auf:
- in Antwort auf eine Auswahl der ersten Betriebsart, Ansteuern der Antriebseinheit durch die Steuer- und Regelungseinheit mit einem der ersten Betriebsart zugeordneten ersten Ansteuerungsmodus, welchem eine bürstenlose Gleichstrommotor-Logik zugeordnet ist,
- in Antwort auf eine Auswahl der zweiten Betriebsart, Ansteuern der Antriebseinheit durch die Steuer- und Regelungseinheit mit einem der zweiten Betriebsart zugeordneten zweiten Ansteuerungsmodus, welchem eine Schrittmotor-Logik zugeordnet ist, und
- Antreiben der Antriebseinheit im ersten Ansteuerungsmodus, oder Antreiben der Antriebseinheit im zweiten Ansteuerungsmodus, wobei die Antriebseinheit jeweils mit einer Vielzahl von Antriebsspannungen antreibbar ist, welche der gewählten Betriebsart zugeordnet ist und in Abhängigkeit von einer aktuellen Winkelstellung der Spindel ermittelt wird.

Die Erfindung ermöglicht somit die Bereitstellung eines Verfahrens zum Betreiben eines Rotationslasers, bei dem ein Betrieb in einem ersten oder zweiten Betriebsmodus durch eine Bereitstellung eines ersten Ansteuerungsmodus und eines zweiten Ansteuerungsmodus ermöglicht werden kann.

Vorzugsweise steuert die Steuer- und Regelungseinheit im ersten Ansteuerungsmodus zur Erzeugung einer Rotation die Antriebseinheit derart an, dass ein Magnetfeld des Stators einem Magnetfeld des Rotors in einer vorgegebenen Rotationsrichtung um 90° vorauseilt, und dass die Amplitude des Magnetfelds des Rotors in Abhängigkeit von einer Änderungsrate der aktuellen Winkelstellung derart geregelt wird, dass die Antriebseinheit in einer vorgegebenen Rotationsgeschwindigkeit rotiert.

Somit kann auf einfache Art und Weise ein geeigneter erster Ansteuerungsmodus bereitgestellt werden.

Bevorzugt erfolgt im zweiten Ansteuerungsmodus nach einer Ermittlung der aktuellen Winkelstellung der Spindel eine Abfrage, ob die aktuelle Winkelstellung einer vorgegebenen Winkelstellung entspricht.

Somit kann leicht und unkompliziert eine Überprüfung einer aktuellen Winkelstellung ermöglicht werden.

Vorzugsweise steuert die Steuer- und Regelungseinheit die Antriebseinheit zum Einstellen der vorgegebenen Winkelstellung der Spindel an, falls die aktuelle Winkelstellung nicht der vorgegebenen Winkelstellung entspricht.

Somit kann einfach und zuverlässig eine Einstellung der vorgegebenen Winkelstellung ermöglicht werden.

Bevorzugt erzeugt die Steuer- und Regelungseinheit im zweiten Ansteuerungsmodus ein elektromagnetisches Haltemoment zur Herbeiführung eines Stillstands der Spindel in der vorgegebenen Winkelstellung.

Somit kann auf einfache Art und Weise ein geeigneter zweiter Ansteuerungsmodus bereitgestellt werden.

Vorzugsweise erzeugt ein dem Stator zugeordnetes Magnetfeld das elektromagnetische Haltemoment.

Somit kann leicht und unkompliziert das elektromagnetische Haltemoment erzeugt werden.

Die Steuer- und Regelungseinheit steuert bevorzugt im zweiten Ansteuerungsmodus die Antriebseinheit derart an, dass komplexe Bewegungsmuster der Spindel und/oder eine Pendelbewegung in einem vorgegebenen Winkelbereich erfolgen.

Somit können einfach und zuverlässig im zweiten Ansteuerungsmodus anwendungsspezifische Bewegungen der Spindel ermöglicht werden.

Des Weiteren betrifft die vorliegende Erfindung einen Rotationslaser mit einem Gehäuse, der in zumindest einer ersten Betriebsart oder einer zweiten Betriebsart betreibbar ist, wobei in dem Gehäuse zur Rotation eines Laserstrahls eine Antriebseinheit mit einem Stator und einem Rotor zum rotierenden Antreiben einer Spindel angeordnet ist, wobei der Antriebseinheit eine Steuer- und Regelungseinheit zum Ansteuern der Antriebseinheit zugeordnet ist. In der ersten Betriebsart steuert die Steuer- und Regelungseinheit die Antriebseinheit mit einem der ersten Betriebsart zugeordneten, ersten Ansteuerungsmodus an, welchem eine bürstenlose Gleichstrommotor-Logik zugeordnet ist, und in der zweiten Betriebsart steuert die Steuer- und Regelungseinheit die Antriebseinheit mit einem der zweiten Betriebsart zugeordneten, zweiten Ansteuerungsmodus an, welchem eine Schrittmotor-Logik zugeordnet ist.

Die Erfindung ermöglicht somit die Bereitstellung eines Rotationslasers, bei dem ein Betrieb in einem ersten oder zweiten Betriebsmodus durch eine Bereitstellung eines ersten Ansteuerungsmodus und eines zweiten Ansteuerungsmodus ermöglicht werden kann.

Vorzugsweise ist die Antriebseinheit jeweils mit einer Vielzahl von Antriebsspannungen antreibbar, welche der gewählten Betriebsart zugeordnet ist und in Abhängigkeit von einer aktuellen Winkelstellung der Spindel ermittelbar ist.

Somit kann leicht und unkompliziert ein Betrieb des Rotationslasers in der gewählten Betriebsart ermöglicht werden.

Bevorzugt erzeugt der Rotor ein erstes Magnetfeld und der Stator erzeugt ein zweites Magnetfeld, wobei eine Ausrichtung des ersten und zweiten Magnetfelds durch ein Antreiben der Antriebseinheit mit der der jeweiligen Betriebsart zugeordneten Vielzahl von Antriebsspannungen erfolgt.

Somit können auf einfache Art und Weise die erste und zweite Betriebsart bzw. der erste und zweite Ansteuerungsmodus bereitgestellt werden.

Der Rotor weist vorzugsweise eine mit der Spindel drehbare Zahnscheibe mit einer Innenaufnahme auf, wobei in der Innenaufnahme eine Magnetscheibe zur Erzeugung des ersten Magnetfelds angeordnet ist.

Somit kann einfach und zuverlässig das erste Magnetfeld erzeugt werden.

Vorzugsweise weist der Stator eine drehfeste Leiterplatte mit mindestens zwei der Magnetscheibe zugewandten Spulen zur Erzeugung des zweiten Magnetfelds auf.

Somit kann leicht und sicher das zweite Magnetfeld erzeugt werden.

Bevorzugt ist der Leiterplatte ein Winkelsensor zur Detektion der aktuellen Winkelstellung der Spindel zugeordnet.

Somit kann auf einfache Art und Weise eine Ermittlung der aktuellen Winkelstellung der Spindel ermöglicht werden.

Vorzugsweise ist der Winkelsensor als Lichtschranke ausgebildet.

Somit kann einfach und unkompliziert ein geeigneter Winkelsensor bereitgestellt werden.

### Kurze Beschreibung der Zeichnungen

Die Erfindung ist anhand von in den Zeichnungen dargestellten Ausführungsbeispielen in der nachfolgenden Beschreibung näher erläutert. Es zeigen:
- Fig. 1: eine perspektivische Ansicht eines erfindungsgemäßen Rotationslasers mit einer Antriebseinheit,
- Fig. 2: eine perspektivische Ansicht der Antriebseinheit mit der Spindel und der Ermittlungseinheit des Rotationslasers von Fig. 1,
- Fig. 3: eine Draufsicht auf eine der Antriebseinheit von Fig. 1 und Fig. 2 zugeordnete Leiterplatte,
- Fig. 4: eine perspektivische Ansicht der Spindel mit der Ermittlungseinheit von Fig. 1 und Fig. 2, und
- Fig. 5: ein Flussdiagramm eines Verfahrens zum Betreiben der Antriebseinheit von Fig. 1 und Fig. 2.

### Beschreibung der Ausführungsbeispiele

In den Figuren werden Elemente mit gleicher oder vergleichbarer Funktion mit identischen Bezugszeichen versehen und nur einmal genauer beschrieben.

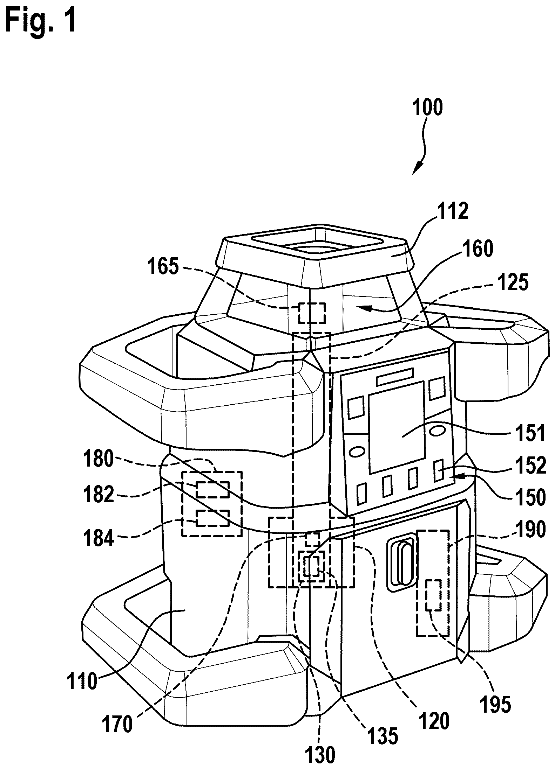

Fig. 1 zeigt einen beispielhaften Rotationslaser 100 mit einem Gehäuse 110, in dem eine Lasereinheit 130 mit einer Laserdiode 135 zur Erzeugung eines Laserstrahls angeordnet ist. Unter einem "Rotationslaser" kann im Kontext der vorliegenden Erfindung auch ein Baulaser oder ein Nivellierlaser verstanden werden. Des Weiteren ist in dem Gehäuse 110 beispielhaft eine Antriebseinheit 120 zum rotierenden Antrieb einer Spindel 125 angeordnet.

Die Lasereinheit 130 ist illustrativ derart an der Spindel 125 angeordnet, dass durch eine Rotation der Spindel 125 der von der Lasereinheit 130 erzeugte Laserstrahl in einer zugeordneten Ebene rotiert. Hierzu ist der Spindel 125 vorzugsweise ein Rotationskopf 160 mit einem Strahlenumleiter 165 zugeordnet. Der Strahlenumleiter 165 ist bevorzugt dazu ausgebildet, den Laserstrahl umzulenken, wodurch der Laserstrahl die zugeordnete Ebene projiziert. Je nach Bauart des Rotationslasers 100 kann die projizierte Ebene horizontal, vertikal oder z.B. mit einem definierten Neigungswinkel zur Erdoberfläche verlaufen. Vorzugsweise ist die Antriebseinheit 120 als Elektromotor ausgebildet.

Darüber hinaus ist in dem Gehäuse 110 bevorzugt eine Elektronikeinheit 190 mit einer Regelungs- und Überwachungsvorrichtung 195 angeordnet. Die Regelungs- und Überwachungsvorrichtung 195 ist vorzugsweise zur Regelung einer Laserleistung der Lasereinheit 130 in Abhängigkeit von einer Betriebsart ausgebildet. Hierbei wird eine Rotationsgeschwindigkeit der Spindel 125 der Antriebseinheit 120 gesteuert oder geregelt. Hierzu ist der Spindel 125 bevorzugt eine Ermittlungseinheit 170 zugeordnet.

Gemäß einer Ausführungsform ist dem Gehäuse 110 ein dem Rotationskopf 160 zugeordneter Schutzkäfig 112 zum Schutz vor einem Anschlagen des Rotationskopfs 160 zugeordnet.

Der Elektronikeinheit 190 ist bevorzugt eine Bedieneinheit 150 mit einem Display 151 und einer Eingabeeinheit 152 zugeordnet. Die Bedieneinheit 150 ist dabei bevorzugt steuer- oder regeltechnisch mit der Elektronikeinheit 190, insbesondere mit der Regelungs- und Überwachungsvorrichtung 195, verbunden. Die Eingabeeinheit 152 umfasst vorzugsweise zumindest ein Tastenfeld. Alternativ weist die Eingabeeinheit 152 einen Drehregler, einen Touchscreen, einen Schieberegler, eine Fernbedienung oder dergleichen auf. Über die Eingabeeinheit 152 ist durch einen Nutzer z.B. eine Rotationsgeschwindigkeit für die Spindel 125 eingebbar. Alternativ ist die Rotationsgeschwindigkeit der Lasereinheit 130 in einer Betriebsart automatisch regelbar.

Vorzugsweise weist der Rotationslaser 100 eine Nivelliereinheit 180 auf. Die Nivelliereinheit 180 weist bevorzugt zumindest einen Neigungssensor 184 auf, der dazu ausgebildet ist, eine Neigung des Rotationskopfs 160, insbesondere des Strahlenumleiters 165, und/oder der Lasereinheit 130 zu einer vorgegebenen, bevorzugt horizontalen Richtung bzw. zu einem Lot zu bestimmen. Darüber hinaus weist die Nivelliereinheit 180 vorzugsweise mindestens einen Neigungseinstellmotor 182 auf, der dazu ausgebildet ist, den Rotationskopf 160, insbesondere den Strahlenumleiter 165, und/oder die Lasereinheit 130, in Abhängigkeit von einer mittels des zumindest einen Neigungssensors 184 bestimmten Lage, vorzugsweise einer Neigung der Lasereinheit 130 und/oder des Rotationskopfs 160, bevorzugt zum Lot auszurichten.

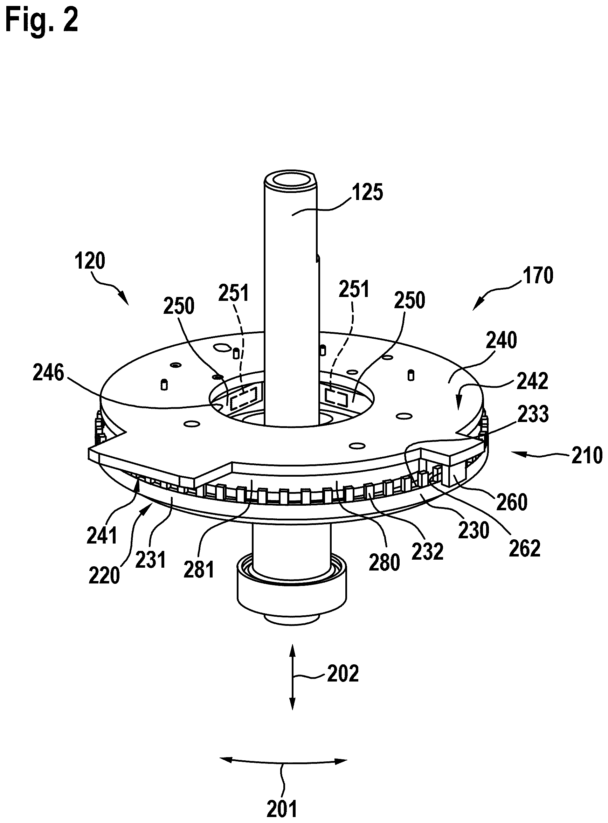

Fig. 2 zeigt die Antriebseinheit 120 mit der Spindel 125 und die Ermittlungseinheit 170 des Rotationslasers 100 von Fig. 1. Die Antriebseinheit 120 weist vorzugsweise einen Stator 210 und einen Rotor 220 zum rotierenden Antrieb der Spindel 125 auf. Bevorzugt ist die Antriebseinheit 120 als Spindelmotor ausgebildet. Hierbei ist die Antriebseinheit 120 vorzugsweise als bürstenloser Gleichstrommotor ausgebildet. Dem Rotor 220 ist beispielhaft eine Magnetscheibe 280 zugeordnet und dem Stator 210 sind zumindest zwei Spulen 251 zugeordnet. Durch eine Bestromung der Spulen 251 kann die Spindel 125 in einer Betriebsart vorzugsweise in Rotation versetzt werden.

Vorzugsweise ist der Spindel 125 die Ermittlungseinheit 170 zugeordnet. Die Ermittlungseinheit 170 weist beispielhaft eine Zahnscheibe 230 und eine Lichtschranke 260 auf. Die Zahnscheibe 230 bildet bevorzugt mit der Lichtschranke 260 eine funktionale Einheit aus, bei der die Zahnscheibe 230 eine Impulsfolge in der Lichtschranke 260 zur Ermittlung der Winkelstellung maßgeblich erzeugt.

Bevorzugt ist die Zahnscheibe 230 drehfest mit der Spindel 125 verbunden. Gemäß einer Ausführungsform ist die Zahnscheibe 230 einstückig mit der Spindel 125 ausgebildet. Die Zahnscheibe 230 weist illustrativ einen Grundkörper 231 auf. Vorzugsweise ist der Grundkörper 231 schalenförmig mit einer Aufnahme 233 ausgebildet. Die Aufnahme 233 ist vorzugsweise zur zumindest teilweisen Aufnahme der Magnetscheibe 280 ausgebildet. Bevorzugt weist die Zahnscheibe 230 in Umfangsrichtung 201 verteilt angeordnete Zähne 232 auf. Die Zähne 232 sind dabei illustrativ an einem Außenumfang der Zahnscheibe 230 entlang einer Längserstreckung 202 der Spindel 125 ausgebildet.

Die Lichtschranke 260 ist vorzugsweise zur Ermittlung einer relativen Änderung einer jeweils aktuellen Winkelstellung der Spindel 125 in Umfangsrichtung 201 vorgesehen. Die Lichtschranke 260 ist vorzugsweise als Quadraturencoder ausgebildet. Ein derartiger Quadraturencoder weist bevorzugt zwei Lichtschranken auf, die bevorzugt mit einem Versatz in Umfangsrichtung 201 zueinander angeordnet sind. Den vorzugsweise zwei Lichtschranken 260 ist bevorzugt eine gemeinsame Lichtquelle zugeordnet. Des Weiteren sind den vorzugsweise zwei Lichtschranken 260 zwei bevorzugt separate Fotodioden oder Fototransistoren zugeordnet.

Die Lichtschranke 260 weist illustrativ eine Bodenfläche und eine vorzugsweise U-förmige Aufnahme 262 auf. In der U-förmigen Aufnahme 262 sind vorzugsweise die Zähne 232 der Zahnscheibe 230 zumindest abschnittsweise aufgenommen. Die Bodenfläche der Lichtschranke 260 ist illustrativ an einer der Zahnscheibe 230 zugewandten Unterseite 241 einer Leiterplatte 240 angeordnet.

Die Leiterplatte 240 ist vorzugsweise im Gehäuse 110 des Rotationlasers 100 von Fig. 1 angeordnet. Hierbei ist die Leiterplatte 240 bevorzugt parallel zur Zahnscheibe 230 angeordnet. Beispielhaft weist die Leiterplatte 240 eine Innenausnehmung 246 zur koaxialen Anordnung an der Spindel 125 auf. Die Leiterplatte 240 weist illustrativ eine Oberseite 242 auf, die dem Strahlenumleiter 165 von Fig. 1 zugewandt angeordnet ist, und die Unterseite 241, die beispielhaft der Zahnscheibe 230 zugewandt angeordnet ist. Bevorzugt weist die Leiterplatte 240 die zumindest zwei Spulen 251 auf. Die Spulen 251 sind illustrativ an der der Zahnscheibe 230 zugewandten Unterseite 241 der Leiterplatte 240 angeordnet. Bevorzugt sind die Spulen 251 mittels Spulenhaltern 250 an der Leiterplatte 240 angeordnet. Vorzugsweise sind die Spulenhalter 250 an der Leiterplatte 240 fixiert.

Die Magnetscheibe 280 weist vorzugsweise einen zumindest abschnittsweisen ringförmigen Grundkörper 281 auf. Alternativ kann die Magnetscheibe 280 mindestens zwei Magnetteile aufweisen. Vorzugsweise ist die Magnetscheibe 280 als Permanentmagnet mit N Polpaaren ausgebildet.

Vorzugsweise weist die Ermittlungseinheit 170 eine Referenzmarke als Absolutreferenz auf. Die Referenzmarke ist bevorzugt der Zahnscheibe 230 zugeordnet. Die Referenzmarke kann z.B. als Referenzzahn oder Referenzausnehmung ausgebildet sein. Hierbei weisen die Zähne 232 der Zahnscheibe 230 eine erste Breite auf und der Referenzzahn oder die Referenzausnehmung weist eine zweite Breite auf. Die zweite Breite ist bevorzugt größer als die erste Breite.

Alternativ ist die Referenzmarke als Positioniermerkmal auf der Magnetscheibe 280 ausgebildet und mit einem Absolut-Encoder wirkverbunden. Hierbei ist eine mechanisch definierte Ausrichtung des Strahlenumleiters 165 von Fig. 1, der Magnetscheibe 280 und der Zahnscheibe 230 zueinander nicht erforderlich. Eine Absolut-Positionierung erfolgt bevorzugt mittels eines zusätzlichen Bauteils, z.B. eines reflektiven Lichtsensors, hier beispielhaft in Form eines Absolut-Encoders auf der Leiterplatte 240 sowie eines Positioniermerkmals auf der Magnetscheibe 280. Das Positioniermerkmal ist vorzugsweise ein reflektierender oder lichtabsorbierender Aufkleber.

Das Positioniermerkmal ist bevorzugt dazu ausgebildet, eines der Polpaare der Magnetscheibe 280 zu identifizieren. Umfasst die Magnetscheibe 280 N Polpaare, so muss das Positioniermerkmal die Identifikation eines Winkelbereichs einer Breite kleiner als 360°/N erlauben. Bevorzugt weist das Positioniermerkmal in Umfangsrichtung 201 der Spindel 125 eine Breite von 180°/N auf. Innerhalb eines jeweils identifizierten Polpaars erfolgt eine genaue Positionsbestimmung über den (elektrischen) Winkel eines durch die Spulen 251 erzeugten Magnetfelds. Die Bestimmung dieses Winkels erfolgt vorzugsweise im Fertigungsprozess durch eine beliebige Winkelpositionierung der Spindel 125 mittels des Spulenfelds innerhalb des Positioniermerkmals.

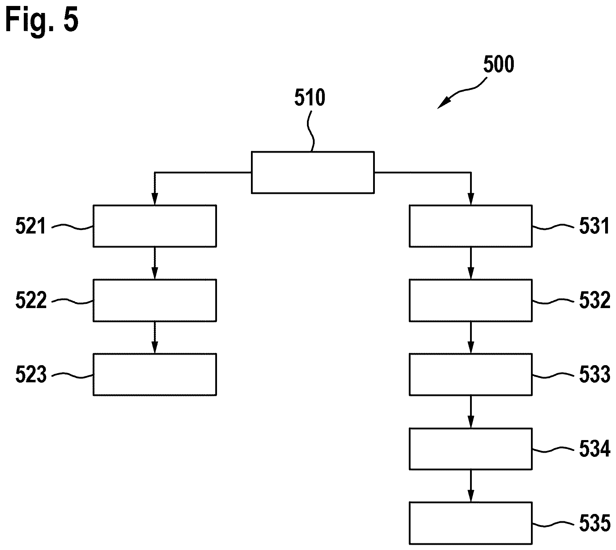

Der Rotationslaser 100 ist in zumindest einer ersten Betriebsart und/oder einer zweiten Betriebsart betreibbar, wobei vorzugsweise jeweils lediglich eine der Betriebsarten aktiv ist. In der ersten Betriebsart steuert die Steuer- und Regelungseinheit 195 die Antriebseinheit 120 vorzugsweise mit einem der ersten Betriebsart zugeordneten, ersten Ansteuerungsmodus an, welchem eine bürstenlose Gleichstrommotor-Logik (521 in Fig. 5) zugeordnet ist. In der zweiten Betriebsart steuert die Steuer- und Regelungseinheit 195 die Antriebseinheit 120 bevorzugt mit einem der zweiten Betriebsart zugeordneten, zweiten Ansteuerungsmodus an, welchem eine Schrittmotor-Logik (531 in Fig. 5) zugeordnet ist.

Die Antriebseinheit 120 ist vorzugsweise jeweils mit einer Vielzahl von Antriebsspannungen (523, 534 in Fig. 5) antreibbar, welche der gewählten Betriebsart zugeordnet ist. Die Vielzahl von Antriebsspannungen (523, 534 in Fig. 5) ist in Abhängigkeit von einer aktuellen Winkelstellung (522, 532 in Fig. 5) der Spindel 125 ermittelbar.

Vorzugsweise erzeugt der Rotor 220 ein erstes Magnetfeld und der Stator 210 erzeugt ein zweites Magnetfeld. Eine Ausrichtung des ersten und zweiten Magnetfelds erfolgt vorzugsweise durch ein Antreiben der Antriebseinheit 120 mit der der jeweiligen Betriebsart zugeordneten Vielzahl von Antriebsspannungen (523, 534 in Fig. 5). Dabei weist, wie oben beschrieben, der Rotor 220 die mit der Spindel 125 drehbare Zahnscheibe 230 auf, wobei in der Innenaufnahme 233 der Zahnscheibe 230 die Magnetscheibe 280 zur Erzeugung des ersten Magnetfelds angeordnet ist. Des Weiteren weist der Stator 210 die drehfeste Leiterplatte 240 mit den mindestens zwei der Magnetscheibe 280 zugewandten Spulen 251 zur Erzeugung des zweiten Magnetfelds auf.

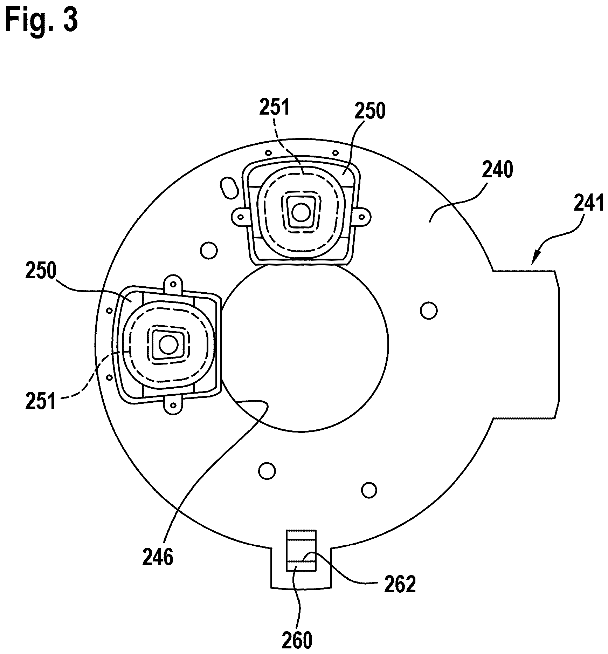

Fig. 3 zeigt die Leiterplatte 240 von Fig. 2 von ihrer Unterseite 241 aus gesehen. Wie oben beschrieben, sind vorzugsweise zwei Spulen 251 mittels eines Spulenhalters 250 an der Unterseite 241 der Leiterplatte 240 angeordnet. Des Weiteren ist die Lichtschranke 260 bevorzugt an der Unterseite 241 der Leiterplatte 240 angeordnet. Illustrativ sind die beiden Spulen 251 um 90° versetzt zueinander angeordnet. Bevorzugt ist die Lichtschranke 260 gegenüberliegend, bzw. um 180° versetzt zu einer der zwei Spulen 251 angeordnet.

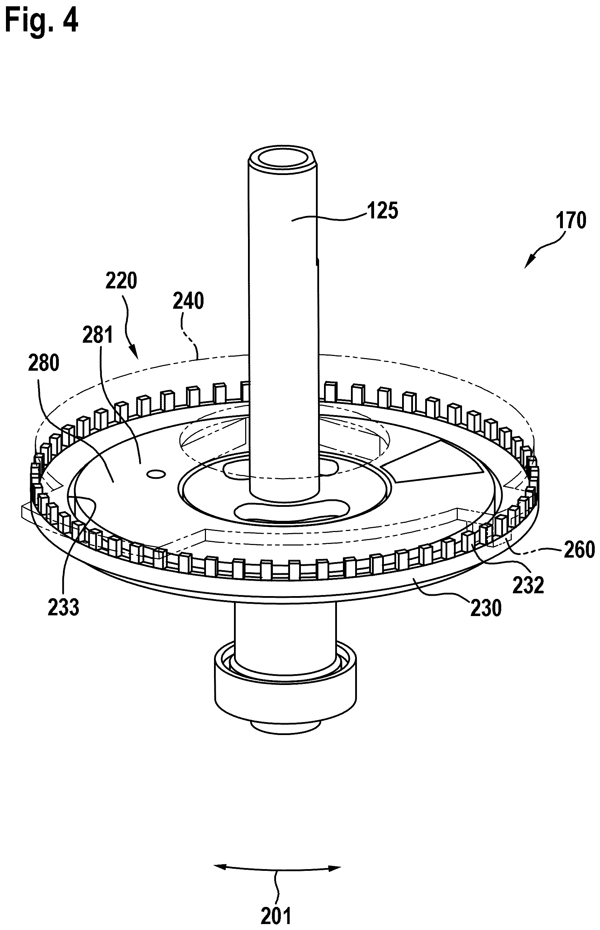

Fig. 4 zeigt den Rotor 220 mit der Zahnscheibe 230, der Magnetscheibe 280, sowie der Leiterplatte 240 von Fig. 2, die zur besseren Verdeutlichung transparent dargestellt ist. Die Zahnscheibe 230 weist die in Umfangsrichtung 201 verteilt angeordneten Zähne 232 auf.

Fig. 5 zeigt ein beispielhaftes Verfahren 500 zum Betreiben des Rotationslasers 100 von Fig. 1 bzw. der Antriebseinheit 120 von Fig. 1 und Fig. 2. Bei dem Verfahren 500 erfolgt zuerst eine Abfrage 510 der Betriebsart, d.h. ob die erste oder zweite Betriebsart aktiviert wurde. Eine derartige Aktivierung der Betriebsart erfolgt vorzugsweise über die Bedieneinheit 150 mit der Eingabeeinheit 152 des Rotationslasers 100 von Fig. 1 durch einen Benutzer des Rotationslasers 100 von Fig. 1.

In Antwort auf eine Auswahl der ersten Betriebsart erfolgt ein Ansteuern der Antriebseinheit 120 von Fig. 1 und Fig. 2 durch die Steuer- und Regelungseinheit 195 von Fig. 1 mit dem der ersten Betriebsart zugeordneten, ersten Ansteuerungsmodus, welchem eine bürstenlose Gleichstrommotor-Logik 521 zugeordnet ist. Hierbei wird die als bürstenloser Gleichstrommotor ausgebildete Antriebseinheit 120 von Fig. 1 und Fig. 2 rotierend angetrieben. Die erste Betriebsart ist bevorzugt ein Rotationsmodus des Rotationslasers 100 von Fig. 1. Bevorzugt wird die Antriebseinheit 120 von Fig. 1 und Fig. 2 dabei durch eine Sinuskommutierung, bei der die Spulen 251 von Fig. 2 und Fig. 3 entsprechend dem Sinus des relativen Winkels zwischen den Spulen 251 von Fig. 2 und Fig. 3 und dem Magnetfeld des Rotors 220 von Fig. 2 und Fig. 4 angesteuert werden, erregt. Bevorzugt wird dabei die Antriebseinheit 120 von Fig. 1 und Fig. 2 mit einer konstanten Geschwindigkeit angetrieben.

In Antwort auf eine Auswahl der zweiten Betriebsart erfolgt ein Ansteuern der Antriebseinheit 120 von Fig. 1 und Fig. 2 durch die Steuer- und Regelungseinheit 195 von Fig. 1 mit einem der zweiten Betriebsart zugeordneten zweiten Ansteuerungsmodus, welchem eine Schrittmotor-Logik 531 zugeordnet ist. Vorzugsweise ist die zweite Betriebsart ein Punktmodus, bei dem die Spindel 125 von Fig. 1, Fig. 2 und Fig. 4 an einer vorgegebenen Winkelstellung oder in einem vorgegebenen Winkelbereich angeordnet ist. Die Antriebseinheit 120 von Fig. 1 und Fig. 2 wird anschließend im ausgewählten Ansteuerungsmodus angetrieben, wobei die Antriebseinheit 120 von Fig. 1 und Fig. 2 jeweils mit einer Vielzahl von Antriebsspannungen 523, 534 angetrieben wird, welche der gewählten Betriebsart zugeordnet ist und in Abhängigkeit von einer aktuellen Winkelstellung 522, 532 der Spindel 125 von Fig. 1, Fig. 2 und Fig. 4 ermittelt wird.

So wird in der ersten Betriebsart, bzw. im ersten Ansteuerungsmodus, die bürstenlose Gleichstrommotor-Logik 521 aktiviert, anschließend die aktuelle Winkelstellung 522 der Spindel 125 von Fig. 1, Fig. 2 und Fig. 4 ermittelt und in Abhängigkeit von der aktuellen Winkelstellung 522 die Antriebsspannung 523 ermittelt und eingestellt.

Bevorzugt wird die Steuer- und Regelungseinheit 195 von Fig. 1 im ersten Ansteuerungsmodus zur Erzeugung einer Rotation der Antriebseinheit 120 von Fig. 1 und Fig. 2, bzw. der Spindel 125 von Fig. 1, Fig. 2 und Fig. 4, derart angesteuert, dass ein Magnetfeld des Stators 210 von Fig. 2 einem Magnetfeld des Rotors 220 von Fig. 2 und Fig. 4 in einer vorgegebenen Rotationsrichtung um 90° vorauseilt. Des Weiteren wird die Amplitude des Magnetfelds des Rotors 220 von Fig. 2 und Fig. 4 in Abhängigkeit von einer Änderungsrate der aktuellen Winkelstellung 522 derart geregelt, dass die Antriebseinheit 120 von Fig. 1 und Fig. 2, bzw. die Spindel 125 von Fig. 1, Fig. 2 und Fig. 4, in einer vorgegebenen Rotationsgeschwindigkeit rotiert.

In der zweiten Betriebsart bzw. im zweiten Ansteuerungsmodus wird die Schrittmotor-Logik 531 aktiviert und anschließend die aktuelle Winkelstellung 532 der Spindel 125 von Fig. 1, Fig. 2 und Fig. 4 ermittelt. Danach erfolgt eine Abfrage 533, ob die aktuelle Winkelstellung 532 mit einer vorgegebenen Winkelstellung übereinstimmt. Stimmt die aktuelle Winkelstellung 532 nicht mit der vorgegebenen Winkelstellung überein, so wird die ausgewählte bzw. vorgegebene Winkelstellung eingestellt. Anschließend wird in Abhängigkeit von der Winkelstellung 532 die Antriebsspannung 534 ermittelt und eingestellt sowie ein elektromagnetisches Haltemoment 535 erzeugt. Das elektromagnetische Haltemoment 535 begrenzt zumindest eine Bewegung der Spindel 125 von Fig. 1, Fig. 2 und Fig. 4. Alternativ erzeugt das elektromagnetische Haltemoment 535 einen Stillstand der Spindel 125 von Fig. 1, Fig. 2 und Fig. 4 in der vorgegebenen Winkelstellung.

Im zweiten Ansteuerungsmodus erfolgt nach einer Ermittlung der aktuellen Winkelstellung 532 der Spindel 125 von Fig. 1, Fig. 2 und Fig. 4 eine Abfrage 533, ob die aktuelle Winkelstellung 532 einer vorgegebenen Winkelstellung entspricht. Vorzugsweise steuert die Steuer- und Regelungseinheit 195 von Fig. 1 die Antriebseinheit 120 von Fig. 1 und Fig. 2 zum Einstellen der vorgegebenen Winkelstellung der Spindel 125 von Fig. 1, Fig. 2 und Fig. 4 rotierend an, falls die aktuelle Winkelstellung 532 nicht der vorgegebenen Winkelstellung entspricht. Des Weiteren erzeugt die Steuer- und Regelungseinheit 195 von Fig. 1 im zweiten Ansteuerungsmodus das elektromagnetische Haltemoment 535 zur Herbeiführung eines Stillstands der Spindel 125 von Fig. 1, Fig. 2 und Fig. 4 in der vorgegebenen Winkelstellung. Bevorzugt erzeugt ein dem Stator 210 von Fig. 2 zugeordnetes Magnetfeld das elektromagnetische Haltemoment 535.

Andere Krafteinflüsse, denen das elektromagnetische Haltemoment vorzugsweise entgegenwirken soll, können z.B. die Schwerkraft (bei möglicher Unwucht einer Spindelnbaugruppe insbesondere im Vertikalbetrieb) oder magnetische/ferromagnetische Rastmomente (mit Einfluss auf die Magnetscheibe 280 von Fig. 2 des Rotors 220 von Fig. 2 und Fig. 4) sein.

Bevorzugt steuert die Steuer- und Regelungseinheit 195 im zweiten Ansteuerungsmodus die Antriebseinheit 120 von Fig. 1 und Fig. 2 bzw. die Spindel 125 von Fig. 1, Fig. 2 und Fig. 4 derart an, dass auch komplexe Bewegungsmuster der Spindel 125 von Fig. 1, Fig. 2 und Fig. 4 und/oder eine Pendelbewegung in einem vorgegebenen Winkelbereich erfolgen können. Komplexe Bewegungsmuster können dabei beliebige Bewegungsabläufe sein. Bei einer derartigen Pendelbewegung in einem vorgegebenen Winkelbereich kann eine Frequenz für die Hin- und Herbewegung der Spindel 125 von Fig. 1, Fig. 2 und Fig. 4 vorzugsweise eingestellt werden.

Vorzugsweise ist eine Antriebsspannung 523, 534 pro Spule 251 von Fig. 2 und Fig. 3 vorgesehen. Das Verhältnis der Antriebsspannungen 523, 534 zueinander und deren Amplitude bestimmen eine Richtung und eine Stärke des dem Stator 210 von Fig. 2 zugeordneten zweiten Magnetfelds. Die erste und zweite Betriebsart unterscheiden sich im Wesentlichen so, wie die Richtung des dem Stator 210 von Fig. 2 zugeordneten zweiten Magnetfelds sich relativ zur Richtung des dem Rotor 220 von Fig. 2 und Fig. 4 zugeordneten ersten Magnetfelds, bzw. der Winkelposition der Spindel 125 von Fig. Fig. 1, Fig. 2 und Fig. 4 verhält.

## Patentansprüche

1. Verfahren (500) zum Betreiben eines Rotationslasers (100), der zumindest in einer ersten Betriebsart oder einer zweiten Betriebsart betreibbar ist und ein Gehäuse (110) aufweist, in dem zur Rotation eines Laserstrahls eine Antriebseinheit (120) mit einem Stator (210) und einem Rotor (220) zum rotierenden Antreiben einer Spindel (125) angeordnet ist, wobei der Antriebseinheit (120) eine Steuer- und Regelungseinheit (195) zum Ansteuern der Antriebseinheit (120) zugeordnet ist, wobei das Verfahren folgende Schritte aufweist:
• in Antwort auf eine Auswahl der ersten Betriebsart, Ansteuern der Antriebseinheit (120) durch die Steuer- und Regelungseinheit (195) mit einem der ersten Betriebsart zugeordneten ersten Ansteuerungsmodus, welchem eine bürstenlose Gleichstrommotor-Logik (521) zugeordnet ist,
• in Antwort auf eine Auswahl der zweiten Betriebsart, Ansteuern der Antriebseinheit (120) durch die Steuer- und Regelungseinheit (195) mit einem der zweiten Betriebsart zugeordneten zweiten Ansteuerungsmodus, welchem eine Schrittmotor-Logik (531) zugeordnet ist, und
• Antreiben der Antriebseinheit (120) im ersten Ansteuerungsmodus, oder Antreiben der Antriebseinheit (120) im zweiten Ansteuerungsmodus, wobei die Antriebseinheit (120) jeweils mit einer Vielzahl von Antriebsspannungen (523, 534) antreibbar ist, welche der gewählten Betriebsart zugeordnet ist und in Abhängigkeit von einer aktuellen Winkelstellung (522, 532) der Spindel (125) ermittelt wird.

2. Verfahren nach Anspruch 1, **dadurch gekennzeichnet, dass** die Steuer- und Regelungseinheit (195) im ersten Ansteuerungsmodus zur Erzeugung einer Rotation die Antriebseinheit (120) derart ansteuert, dass ein Magnetfeld des Stators (210) einem Magnetfeld des Rotors (220) in einer vorgegebenen Rotationsrichtung um 90° vorauseilt, und dass die Amplitude des Magnetfelds des Rotors (220) in Abhängigkeit von einer Änderungsrate der aktuellen Winkelstellung (532) derart geregelt wird, dass die Antriebseinheit (120) in einer vorgegebenen Rotationsgeschwindigkeit rotiert.

3. Verfahren nach Anspruch 1 oder 2, **dadurch gekennzeichnet, dass** im zweiten Ansteuerungsmodus nach einer Ermittlung der aktuellen Winkelstellung (532) der Spindel (125) eine Abfrage (533) erfolgt, ob die aktuelle Winkelstellung (532) einer vorgegebenen Winkelstellung entspricht.

4. Verfahren nach Anspruch 3, **dadurch gekennzeichnet, dass** die Steuer- und Regelungseinheit (195) die Antriebseinheit (120) zum Einstellen der vorgegebenen Winkelstellung der Spindel (125) ansteuert, falls die aktuelle Winkelstellung (532) nicht der vorgegebenen Winkelstellung entspricht.

5. Verfahren nach Anspruch 3 oder 4, **dadurch gekennzeichnet, dass** die Steuer- und Regelungseinheit (195) im zweiten Ansteuerungsmodus ein elektromagnetisches Haltemoment (535) zur Herbeiführung eines Stillstands der Spindel (125) in der vorgegebenen Winkelstellung erzeugt.

6. Verfahren nach Anspruch 5, **dadurch gekennzeichnet, dass** ein dem Stator (210) zugeordnetes Magnetfeld das elektromagnetische Haltemoment (535) erzeugt.

7. Verfahren nach einem der vorhergehenden Ansprüche, **dadurch gekennzeichnet, dass** die Steuer- und Regelungseinheit (195) im zweiten Ansteuerungsmodus die Antriebseinheit (120) derart ansteuert, dass komplexe Bewegungsmuster der Spindel (125) und/oder eine Pendelbewegung in einem vorgegebenen Winkelbereich erfolgen.

8. Rotationslaser (100) mit einem Gehäuse (110), der in zumindest einer ersten Betriebsart oder einer zweiten Betriebsart betreibbar ist, wobei in dem Gehäuse (110) zur Rotation eines Laserstrahls eine Antriebseinheit (120) mit einem Stator (210) und einem Rotor (220) zum rotierenden Antreiben einer Spindel (125) angeordnet ist, wobei der Antriebseinheit (120) eine Steuer- und Regelungseinheit (195) zum Ansteuern der Antriebseinheit (120) zugeordnet ist, **dadurch gekennzeichnet, dass** in der ersten Betriebsart die Steuer- und Regelungseinheit (195) die Antriebseinheit (120) mit einem der ersten Betriebsart zugeordneten, ersten Ansteuerungsmodus ansteuert, welchem eine bürstenlose Gleichstrommotor-Logik (521) zugeordnet ist, und dass in der zweiten Betriebsart die Steuer- und Regelungseinheit (195) die Antriebseinheit (120) mit einem der zweiten Betriebsart zugeordneten, zweiten Ansteuerungsmodus ansteuert, welchem eine Schrittmotor-Logik (531) zugeordnet ist.

9. Rotationslaser nach Anspruch 8, **dadurch gekennzeichnet, dass** die Antriebseinheit (120) jeweils mit einer Vielzahl von Antriebsspannungen (523, 534) antreibbar ist, welche der gewählten Betriebsart zugeordnet ist und in Abhängigkeit von einer aktuellen Winkelstellung (522, 532) der Spindel (125) ermittelbar ist.

10. Rotationslaser nach Anspruch 8 oder 9, **dadurch gekennzeichnet, dass** der Rotor (220) ein erstes Magnetfeld erzeugt und der Stator (210) ein zweites Magnetfeld erzeugt, wobei eine Ausrichtung des ersten und zweiten Magnetfelds durch ein Antreiben der Antriebseinheit (120) mit der der jeweiligen Betriebsart zugeordneten Vielzahl von Antriebsspannungen (523, 534) erfolgt.

11. Rotationslaser nach Anspruch 10, **dadurch gekennzeichnet, dass** der Rotor (220) eine mit der Spindel (125) drehbare Zahnscheibe (230) mit einer Innenaufnahme (233) aufweist, wobei in der Innenaufnahme (233) eine Magnetscheibe (280) zur Erzeugung des ersten Magnetfelds angeordnet ist.

12. Rotationslaser nach Anspruch 10 oder 11, **dadurch gekennzeichnet, dass** der Stator (210) eine drehfeste Leiterplatte (240) mit mindestens zwei der Magnetscheibe (280) zugewandten Spulen (251) zur Erzeugung des zweiten Magnetfelds aufweist.

13. Rotationslaser nach Anspruch 12, **dadurch gekennzeichnet, dass** der Leiterplatte (240) ein Winkelsensor (260) zur Detektion der aktuellen Winkelstellung der Spindel (125) zugeordnet ist.

14. Rotationslaser nach Anspruch 13, **dadurch gekennzeichnet, dass** der Winkelsensor (260) als Lichtschranke ausgebildet ist.
